# EUROPÄISCHE PATENTSCHRIFT

(11) **EP 3 938 739 B1**
(45) Veröffentlichungstag und Bekanntmachung des Hinweises auf die Patenterteilung: **15.11.2023**
(21) Anmeldenummer: 20705357.0
(22) Anmeldetag: 14.02.2020
(51) Int. Cl.: H05K 1/11, H05K 1/16, H05K 3/40, G01F 1/84

(54) **FELDGERÄT DER PROZESSMESSTECHNIK, MESSAUFNEHMER UND VERFAHREN ZUR HERSTELLUNG EINER SPULENVORRICHTUNG**
FIELD DEVICE OF PROCESS MEASUREMENT TECHNOLOGY, MEASURING SENSOR AND METHOD FOR PRODUCING A COIL APPARATUS
APPAREIL DE TERRAIN DE LA MÉTROLOGIE DE PROCESSUS, ENREGISTREUR DE MESURE ET PROCÉDÉ DE FABRICATION D'UN DISPOSITIF À BOBINE

(30) Priorität: 12.03.2019 DE 102019106244
(43) Veröffentlichungstag der Anmeldung: 19.01.2022
(73) Patentinhaber: Endress + Hauser Flowtec AG, 4153 Reinach (CH)
(72) Erfinder: SCHWENTER, Benjamin, 4147 Aesch (CH); STUCKI, Martin, 4133 Pratteln (CH); HOLLINGER, Claude, 4147 Aesch (CH); WERNER, Marc, 79639 Grenzach-Wyhlen (DE)
(74) Vertreter: Penner, Paul
(86) Internationale Anmeldenummer: PCT/EP2020/053905
(87) Internationale Veröffentlichungsnummer: WO 2020/182409

(56) Entgegenhaltungen:
- DE-A1-102015 120 087
- GB-A- 1 117 719
- JP-A- H0 620 731
- US-A- 3 557 300
- US-A- 4 524 038
- US-A- 5 992 725
- US-B2- 8 110 753

## Beschreibung

Die Erfindung betrifft ein Feldgerät der Prozessmesstechnik, eine Leiterplattenspule und eine Methode zum Kontaktieren einer Leiterplattenspule.

Feldgeräte der Prozessmesstechnik mit einem Messaufnehmer vom Vibrationstyp und besonders Coriolis-Durchflussmessgeräte sind seit vielen Jahren bekannt. Der grundsätzliche Aufbau eines solchen Messgeräts wird beispielsweise in der EP 1 807 681 A1 beschrieben, wobei auf den Aufbau eines gattungsgemäßen Feldgeräts im Rahmen der vorliegenden Erfindung auf diese Druckschrift vollumfänglich Bezug genommen wird.

Typischerweise weisen Coriolis-Durchflussmessgeräte zumindest ein oder mehrere schwingfähige Messrohre auf, welche mittels eines Schwingungserregers in Schwingung versetzt werden können. Diese Schwingungen übertragen sich über die Rohrlänge und werden durch die Art des im Messrohr befindlichen fließfähigen Mediums und dessen Durchflussgeschwindigkeit variiert. Ein Schwingungssensor oder insbesondere zwei voneinander beabstandete Schwingungssensoren können an einer anderen Stelle des Messrohres die variierten Schwingungen in Form eines Messsignals oder mehrerer Messsignale aufnehmen. Aus dem oder den Messsignalen kann eine Auswerteeinheit sodann den Durchfluss und/oder die Dichte des Mediums ermitteln.

Entsprechende Schwingungserreger und/oder Schwingungssensoren beruhen zumeist auf einem elektrodynamischen Prinzip und sind zumeist mehrteilig aufgebaut und umfassen eine Magnetvorrichtung zur Erzeugung eines Magnetfeldes und eine von diesem Magnetfeld durchsetzte Spule. Diese Spule besteht üblicherweise aus Draht und ist auf einen Spulenkörper, typischerweise einem zylindrischen Spulenkörper, gewickelt. Diese Technologie hat sich grundsätzlich bewährt.

Es gibt allerdings Anwendungen, z.B. Anwendungen bei Mediumstemperaturen von über 250°C, in welchen ein Coriolis-Durchflussmessgerät genutzt wird, welche besonders hohe Anforderungen an den Schwingunssensor- und den Schwingungserregeraufbau stellen und wo eine hohe Wicklungsdichte der Spulen bei guter Isolation der Leiterbahnen untereinander benötigt wird.

Die DE 10 2015 120 087 A1 offenbart ein Messgerät mit einer Spulenvorrichtung, welche eine Leiterplatte, bestehend aus Niedertemperatur-Einbrand-Keramik, und eine Leiterplattenspule umfasst. Die Leiterplattenspule weist zwei Kontaktierungselemente auf, die für den Anschluss von Anschlusselementen vorgesehen sind. Der Anschluss erfolgt durch einen Schweißvorgang. Nachteilig an diesem Kontaktierverfahren ist, dass die bei der Montage der Spulenvorrichtung an das Messgerät auftretenden Kräfte zum Ablösen des Anschlussdrahtes vom Kontaktierungselement führen.

Ein bekanntes Verfahren zum Verbinden eines Drahtes mit einer leitfähigen Schicht auf einer Keramik ist das in der US 5,992,725 beschriebene Drahtbonden. Alternativ dazu offenbaren die Patentschriften US 4,524,038, GB 1,117,719 und US 8,110,753 B2 jeweils ein Verfahren zum Herstellen einer vibrations- und stosssicheren Verbindung in dem die Verbindung und Kontaktierung mittels eines Sinterverfahrens erfolgt.

Der Erfindung liegt die Aufgabe zugrunde ein Feldgerät, einen Messaufnehmer und ein Verfahren zur Herstellung einer Spulenvorrichtung bereitzustellen, so dass das Risiko eines Ablösens des Anschlusselementes vom Kontaktierungselement minimiert wird.

Die Aufgabe wird gelöst durch den Messaufnehmer nach Anspruch 1, durch das Verfahren zur Herstellung einer Spulenvorrichtung nach Anspruch 7 und durch das Feldgerät nach Anspruch 15.

Ein erfindungsgemäßer Messaufnehmer eines Messgerätes zum Erfassen eines Massedurchflusses, einer Viskosität, einer Dichte und/oder einer davon abgeleiteten Größe eines durch mindestens ein Messrohr des Messaufnehmers strömenden Mediums umfasst das mindestens eine Messrohr mit einem Einlauf und einem Auslauf, welches dazu eingerichtet ist, das Medium zwischen Einlauf und Auslauf zu führen, mindestens einen Schwingungserreger, welcher dazu eingerichtet ist, das mindestens eine Messrohr zu Schwingungen anzuregen und mindestens zwei Schwingungssensoren, welche dazu eingerichtet sind, die Auslenkung der Schwingungen mindestens eines Messrohrs zu erfassen, wobei mindestens ein Schwingungserreger sowie die Schwingungssensoren jeweils eine Spulenvorrichtung mit jeweils mindestens einer Spule, sowie jeweils eine Magnetvorrichtung aufweisen, wobei die Magnetvorrichtung und die Spulenvorrichtung relativ zueinander bewegbar sind, wobei die Magnetvorrichtung und die Spulenvorrichtung eines Schwingungserregers bzw. Schwingungssensors dazu eingerichtet sind, mittels magnetischer Felder miteinander zu wechselwirken, wobei die Spulenvorrichtung eine Leiterplatte mit mindestens einer Leiterplattenschicht umfasst, wobei jede Leiterplattenschicht eine erste Seitenfläche und zur ersten Seitenfläche planparallele zweite Seitenfläche aufweist, wobei die Spule dazu eingerichtet ist ein zeitlich varrierendes Magnetfeld zu erfassen oder zu erzeugen, wobei die Spule zumindest abschnittsweise mittels einer elektrisch leitfähigen Leiterbahn ausgebildet ist, wobei die Spule auf der ersten Seitenfläche und/oder zweiten Seitenfläche einer Leiterplattenschicht angeordnet ist, wobei die Leiterplatte mindestens zwei Kontaktierungselemente umfasst, zum Anschließen der Spule an eine elektronische Mess- und/oder Betriebsschaltung des Messgerätes mittels Anschlusselemente und ist dadurch gekennzeichnet, dass mindestens ein Kontaktierungselement ein Loch aufweist, wobei die Leiterplatte mindestens eine Einbuchtung mit einem Boden aufweist, wobei jeweils ein Kontaktierungselement auf dem Boden jeweils einer Einbuchtung angeordnet ist, wobei das Anschlusselement in der Einbuchtung angeordnet ist, wobei die Einbuchtung zumindest teilweise mit einer festen Metallmikropartikelmasse gefüllt ist, welche das Anschlusselement stoffschlüssig mit der Leiterplatte und dem Kontaktierungselement verbindet und einen elektrischen Kontakt zwischen dem Anschlusselement und dem Kontaktierungselement vermittelt.

Gemäß einer Ausgestaltung ist ein Anschlusselement durch das Loch geführt, so dass das erste Anschlusselement zumindest einseitig, formschlüssig mit der Leiterplatte verbunden ist.

Durch die einseitig, formschlüssige Verbindung des Anschlusselementes an die Leiterplatte wird nicht nur eine ausreichende, mechanische Befestigung, sondern auch ein elektrischer Kontakt zur Leiterplattenspule realisiert.

Gemäß einer Ausgestaltung ist ein Ende des ersten Anschlusselementes zumindest abschnittsweise gebogen, geknickt oder hakenförmig ausgebildet, wobei das Ende in das Loch durchgeführt oder zumindest eingeführt ist.

Ist das Ende des Anschlusselementes gebogen oder geknickt, so werden Zugkräfte, deren Richtung im Wesentlichen parallel zur Oberflächenebene der Leiterplatte zeige, auf die Leiterplatte übertragen. Ist das Ende des Anschlusselementes hakenförmig ausgebildet und so in das Loch eingeführt, dass ein Zurück- oder Herausziehen des Anschlusselementes ohne Verformung ebendieses unmöglich macht, so werden außerdem auch Zugkräfte, deren Richtung im Wesentlichen senkrecht zur Oberflächenebene der Leiterplatte zeigen, auf die Leiterplatte weitergeleitet und ein Ablösen des elektrischen Kontaktes vermieden.

Gemäß einer Ausgestaltung umfasst das Anschlusselement einen Anschlussdraht, der zumindest ein Metall aus folgender Liste aufweist: Silber, Gold, Kupfer, Platin, Tantal, Paladium.

Gemäß einer Ausgestaltung weist die Metallmikropartikelmasse Mikropartikel zumindest eines Metalls aus folgender Liste auf: Silber, Gold, Kupfer, Platin, Tantal, Paladium.

Gemäß einer Ausgestaltung ist das Loch als Durchgangsbohrung ausgebildet und verläuft durch das Kontaktierungselement und die Leiterplatte.

In einer Ausgestaltung weist die Leiterplatte mehrere Leiterplattenschichten auf, welche Leiterplattenschichten gestapelt und über Seitenflächen mit benachbarten Leiterplattenschichten verbunden sind.

In einer Ausgestaltung sind die Kontaktierungselemente entweder auf mindestens einer ersten Seitenfläche oder auf mindestens einer zweiten Seitenfläche angeordnet. Somit sind alle Kontaktierungselemente von einer Aufsicht aus sichtbar.

In einer Ausgestaltung sind die Kontaktierungselemente bezüglich der Schnittebene symmetrisch angeordnet.

In einer Ausgestaltung weist die Leiterplatte eine Anzahl A_Gesamt Leiterplattenschichten auf, wobei A_Gesamt größer 1 ist, wobei die Leiterplatte mindestens eine Einbuchtung aufweist, welche Einbuchtung durch mindestens eine Einkerbung einer zugehörigen zusammenhängenden Gruppe von Leiterplattenschichten ausgebildet ist, wobei eine Anzahl der zur zugehörigen Gruppe gehörenden Leiterplattenschichten kleiner als A_Gesamt ist, wobei ein zu einer Einbuchtung gehörendes Kontaktierungselement auf einer Kontaktierungsleiterplattenschicht angeordnet ist, welche Kontaktierungsleiterplattenschicht an die eine entsprechende Gruppe angrenzt, wobei das Kontaktierungselement einen Boden der Einbuchtung zumindest teilweise ausbildet, wobei die das Kontaktierungselement tragende Leiterplatte zumindest im Bereich des Kontaktierungselements nicht durch eine benachbarte Leiterplatte bedeckt ist. Beispielsweise kann die Einbuchtung zumindest teilweise mittels einer elektrisch leitfähigen Masse gefüllt sein, welche dazu eingerichtet ist, eine elektrische Leitung auf dem Kontaktierungselement zu halten und einen elektrischen Kontakt zwischen elektrischer Leitung und Kontaktierungselement zu verbessern.

In einer Ausgestaltung weist eine Mehrzahl Leiterplattenschichten jeweils eine Spule mit jeweils einem ersten Spulenende und jeweils einem zweiten Spulenende auf, wobei die Spulen seriell und/oder parallel zueinander verschaltet sind, wobei die Spulen verschiedener Leiterplattenschichten bei Anlegen einer elektrischen Spannung zwischen der ersten Durchkontaktierung und der zweiten Durchkontaktierung konstruktiv interferierende Magnetfelder erzeugen.

Durch Zusammenschalten mehrerer Spulen lässt sich eine Empfindlichkeit der Spulenvorrichtung gegenüber einer Magnetfeldänderung im Bereich der Spulenvorrichtung erhöhen, sowie stärkere Magnetfelder erzeugen.

In einer Ausgestaltung sind die ersten Spulenenden mittels einer ersten Durchkontaktierung verbunden, und wobei die zweiten Spulenenden mittels einer zweiten Durchkontaktierung verbunden sind.

In einer Ausgestaltung sind benachbarte Spulen mittels jeweils einem ihrer Spulenenden verbunden, wobei jeweils ein Ende von äußeren Spulen mit jeweils einem Kontaktierungselement verbunden ist.

In einer Ausgestaltung ist eine Differenz eines elektrischen Gleichspannungswiderstands der Spulenvorrichtungen unterschiedlicher Schwingungssensoren geringer als 3% und insbesondere geringer als 2% und bevorzugt geringer als 1% eines Mittelwerts der elektrischen Gleichspannungswiderstände der Spulenvorrichtungen ist.

Ein erfindungsgemäßes Verfahren zur Herstellung einer Spulenvorrichtung nach einem der vorherigen Ansprüchen, umfasst die folgenden Verfahrensschritte:
- Einbringen eines Loches in eines der Kontaktierungselemente, insbesondere eines Durchgangsloches in eines der Kontaktierungselemente und die Leiterplatte;
- Einführen des Anschlusselementes in das Loch;
- teilweises Umschließen des Anschlusselementes und der Kontaktierungselemente mit einer Metallmikropartikelpaste; und
- Trocknen, Aushärten und/oder Sintern der Metallmikropartikelpaste zur Bildung einer Metallmikropartikelmasse.

Eine geeignete Metallmikropartikelpaste lässt sich beispielsweise bei Heraeus Deutschland GmbH Co. KG beziehen. Beispielsweise die Silberpaste mit der Kennzeichnung ASP 131-06 lässt sich für eine Umsetzung der Erfindung nutzen. Es ist besonders vorteilhaft, wenn das Anschlusselement einen Anschlussdraht umfasst, der eine Felxibilität aufweist, In dem Fall kannn der Draht in einem ersten Schritt in das Loch eingeführt werden und dann anträglich verbogen, geknickt oder hakenförmig ausgebildet werden.

Gemäß einer Ausgestaltung weist die Leiterplatte eine Einbuchtung auf in der das Kontaktierungselement angeordnet ist, wobei das Umschließen des Anschlusselementes und der Kontaktierungselemente durch Füllen der Einbuchtung mit der Metallmikropartikelpaste erfolgt.

Beispielsweise kann die Einbuchtung zumindest teilweise mittels einer elektrisch leitfähigen Masse gefüllt sein, welche dazu eingerichtet ist, eine elektrische Leitung auf dem Kontaktierungselement zu halten und einen elektrischen Kontakt zwischen elektrischer Leitung und Kontaktierungselement zu verbessern.

Gemäß einer Ausgestaltung umfasst das Trocknen ein Erwärmen der Metallmikropartikelpaste auf eine Trocknungstemperatur von mindestens 150°C, und insbesondere mindestens 180°C, und bevorzugt mindestens 210°C.

Gemäß einer Ausgestaltung umfasst das Trocknen ein Halten der Trocknungstemperatur über mindestens 20 Minuten, und insbesondere mindestens 35 Minuten, und bevorzugt mindestens 50 Minuten.

Gemäß einer Ausgestaltung umfasst eine Temperaturanpassung von Zimmertemperatur zu Trocknungstemperatur und/oder von Trocknungstemperatur zu Zimmertemperatur eine Zeitdauer von mindestens 20 Minuten, und insbesondere mindestens 35 Minuten, und bevorzugt mindestens 50 Minuten.

Gemäß einer Ausgestaltung weisen Partikel der Metallmikropartikelpaste eine maximale Ausdehnung von kleiner als 50 Mikrometer, und insbesondere kleiner als 35 Mikrometer und bevorzugt kleiner als 20 Mikrometer auf. Je kleiner eine maximale Ausdehnung der Partikel ist, desto größer ist ein Verhältnis einer Partikeloberfläche zu einem Partikelvolumen, so dass Kontaktkräfte zwischen einzelnen Partikeln immer dominanter werden und der Metallmikropartikelpaste eine ausreichende Festigkeit verleihen.

Gemäß einer Ausgestaltung weist die Leiterplatte in einer Randfläche mindestens eine Einbuchtung mit einem Boden und einer Umrandung auf, wobei die Umrandung im Bereich der Metallmikropartikelmasse zumindest abschnittsweise Unebenheiten beispielsweise in Form einer Riffelung oder einer Abstufung auf, welche Unebenheiten dazu eingerichtet sind, die Metallmikropartikelmasse zu halten.

Bevorzugt weisen die Unebenheiten senkrecht zur Umrandung eine Höhe größer als eine halbe maximale Ausdehnung der Partikel auf. Dadurch greift nach Abschluss des Trocknungsprozesses die Metallmikropartikelmasse in die Unebenheiten ein und ist dadurch fest gehalten.

Gemäß einer Ausgestaltung erfolgt das Trocknen der Metallmikropartikelpaste in einer Hochdruckatmosphäre von mindestens 3 Bar, und bevorzugt mindestens 5 Bar und insbesondere mindestens 10 Bar.

Gemäß einer Ausgestaltung ist das Loch mittels eines Stanzverfahrens oder eines Laserverfahrens ausgebildet.

Gemäß einer Ausgestaltung werden zur Bildung der Leiterplatte, vorstrukturierte Leiterplattenschichten, insbesondere Keramikfolien gestapelt und gesintert, wobei das Einbringen des Loches in das Kontaktierungselement vor oder nach dem Sintern erfolgt.

Ein erfindungsgemäßes Feldgerät der Prozessmesstechnik umfasst einen erfindungsgemäßen Messaufnehmer und eine elektronische Mess- und/oder Betriebsschaltung, wobei die elektronische Mess- und/oder Betriebsschaltung dazu eingerichtet ist, die Schwingungssensoren und den Schwingungserreger zu betreiben, und mittels elektrischer Verbindungen mit diesen verbunden ist, wobei die mindestens eine elektrische Verbindung zur elektronischen Mess- und/oder Betriebsschaltung geführt ist, wobei die elektronische Mess- und/oder Betriebsschaltung weiter dazu eingerichtet ist, Durchflussmesswerte und/oder Dichtemesswerte zu ermitteln und bereitzustellen, wobei das Feldgerät insbesondere ein Elektronikgehäuse zum Behausen der elektronischen Mess- und/oder Betriebsschaltung aufweist.

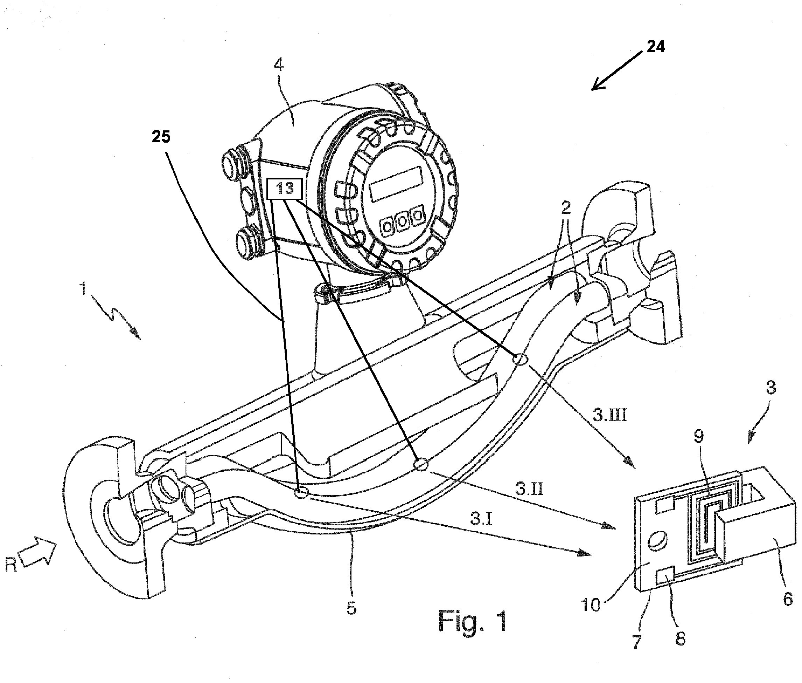

Die Erfindung wird anhand der nachfolgenden Figuren näher erläutert. Es zeigt:
Fig. 1: eine Darstellung eines Feldgerätes nach dem Stand der Technik mit Vergrößerungsausschnitt eines Schwingungssensors/-erregers;
Fig. 2: eine Draufsicht einer Leiterplatte eines Schwingungssensors und/oder Schwingungserregers nach dem Stand der Technik;
Fig. 3: eine Draufsicht und Schrägansicht einer erfindungsgemäßen Spulenvorrichtung;
Fig. 4: eine Nahaufnahme eines Kontaktierungselementes, eines Anschlusselementes und einer Einbuchtung in einer Leiterplatte;
Fig. 5: eine weitere Nahaufnahme von der Rückseite einer erfindungsgemäßen Kontaktiervorrichtung in einer Leiterplatte;
Fig. 6: einen Vergrößerungsausschnitt einer Querschnittsfläche einer erfindungsgemäßen Spulenvorrichtung, insbesondere eines Kontaktierungselementes;
Fig. 7: schematischer Querschnitt einer Leiterplatte bestehend aus mehreren Leiterplattenschichten; und
Fig. 8: eine Ausgestaltung eines Herstellungsverfahrens einer Spulenvorrichtung.
Das Messprinzip eines Coriolis-Durchflussmessgerätes wird nachfolgend anhand eines Zweirohr-Coriolisdurchflussmessgerätes (siehe Fig. 1) kurz erörtert. Es sind jedoch z.B. auch Einrohr- oder 4-Rohr-Coriolisdurchflussmessgeräte bekannt, welche ebenfalls im Rahmen der vorliegenden Erfindung erfasst sind. Das Messprinzip basiert auf der kontrollierten Erzeugung von Corioliskräften. Diese Kräfte treten in einem System immer dann auf, wenn sich gleichzeitig translatorische (geradlinige) und rotatorische (drehende) Bewegungen überlagern. Die Größe der Corioliskraft hängt von der bewegten Masse, deren Geschwindigkeit im System und somit vom Massefluss ab. Anstelle einer konstanten Drehgeschwindigkeit tritt beim Messaufnehmer eine Oszillation auf. Beim Messaufnehmer werden dabei zwei vom Medium durchströmte, parallele Messrohre in Gegenphase zur Schwingung gebracht und bilden eine Art Stimmgabel. Die an den Messrohren erzeugten Corioliskräfte bewirken eine Phasenverschiebung der Rohrschwingung. Bei Nulldurchfluss, also bei Stillstand des Mediums, schwingen beide Messrohre in Phase. Bei Massefluss wird die Rohrschwingung einlaufseitig verzögert und auslaufseitig beschleunigt. Je größer der Massefluss ist, desto größer ist auch die Phasendifferenz der beiden schwingenden Messrohre. Mittels elektrodynamischer Schwingungssensoren wird die Rohrschwingung ein- und auslaufseitig abgegriffen. Die Systembalance wird durch die gegenseitigen Schwingungen der beiden Messrohre erreicht. Das Messprinzip arbeitet grundsätzlich unabhängig von Temperatur, Druck, Viskosität, Leitfähigkeit und Durchflussprofil. Zusätzlich zum Massendurchfluss ist auch eine Dichtemessung des Messmediums möglich. Dabei wird das Messrohr in seiner Resonanzfrequenz angeregt. Sobald sich die Masse und somit die Dichte des schwingenden Systems, also des Messrohrs und des Mediums sich ändert, so wird die Erregerfrequenz nachgeregelt. Die Resonanzfrequenz ist somit eine Funktion der Mediumsdichte. Aufgrund dieser Abhängigkeit lässt sich z.B. mittels eines Mikroprozessors, ein Dichtesignal gewinnen. Durch den Massedurchfluss und der Dichte lässt sich zudem ein Volumendurchfluss ermitteln. Zur rechnerischen Kompensation von Temperatureffekten kann die Temperatur am Messrohr erfasst werden. Dieses Signal entspricht der Prozesstemperatur und steht auch als Ausgangssignal zur Verfügung. Ein Feldgerät 24 nach dem Stand der Technik ist exemplarisch in Fig. 1 als ein Coriolismessgerät dargestellt. Der in Fig. 1 dargestellte Messaufnehmer 1 ist als Zweirohr-Variante dargestellt. Dabei wird ein Messmedium durch zwei parallel zueinander verlaufenden Messrohre 2 geleitet, welche in einem Messaufnehmergehäuse 5 angeordnet sind. Das Messaufnehmergehäuse 5 hat einen länglichen Aufbau und weist an jeweils zwei endständigen Positionen Flansche zum Anschluss an eine Prozessleitung auf. Zudem weist
das Messgerät vorzugsweise einen Messumformer 4 bzw. einen Transmitter auf, in welchem eine Auswerteeinheit angeordnet ist. Aus der vorgenannten Schilderung des Messprinzips ergibt sich, dass ein mit einem Messmedium durchflossenes Messrohr 2 zunächst durch einen Schwingungserreger 3.11 in Schwingungen versetzt werden muss. Und schließlich wird die Schwingungsfrequenz und/oder die Schwingungsamplitude eines Messrohres 2 durch Schwingungssensoren 3.1 und 3.III detektiert. In der abgebildeten Ausgestaltung befindet sich eine Mess- und/oder Betriebsschaltung 13 im Messumformer 4. Diese ist mit den einzelnen Schwingungserregern 3.II und/oder Schwingungssensoren 3.I und 3.III elektrisch verbunden. In Fig. 1 sind der Schwingungserreger 3.II und die Schwingungssensoren 3.I und 3.III baugleich als eine Schwingungssensor/-erreger-Einheit ausgebildet und in einem Vergrößerungsausschnitt dargestellt.

Die Messrohre 2 weisen jeweils eine Biegung auf, wobei der Schwingungserreger 3.II in der Mitte der Biegung, bezogen auf die Längsrichtung der Messrohre 2, angeordnet ist und je einer erster Schwingungssensor 3.I zur Detektion der Schwingungen des Messrohres 2 in einer Strömungsrichtung R vor und ein zweiter Schwingungssensor 3.III zur Detektion der Schwingungen des Messrohres 2 in einer Strömungsrichtung R hinter dem Schwingungserreger 3.II angeordnet ist. Diese Entfernung beider Schwingungssensoren 3.I und 3.III zum Schwingungserreger 3.II ist vorzugsweise gleich groß. Es sind allerdings auch Coriolismessgeräte bekannt, welche Messrohre 2 ohne eine entsprechende Biegung aufweisen.

Im Folgenden wird der Schwingungserreger 3.II und die Schwingungssensoren 3.I und 3.III näher beschrieben. Der Schwingungserreger 3.II und/oder die Schwingungssensoren 3.I und 3.III weisen eine Magnetvorrichtung 6 und eine Leiterplatte 10 auf. Die Magnetvorrichtung 6 kann beispielsweise und bevorzugt einen oder mehrere Dauermagneten aufweisen. Es kann jedoch auch alternativ eine Magnetspule vorgesehen sein. Diese sind in einem geringen Abstand zur Leiterplatte 10 angeordnet, so dass das Magnetfeld zumindest bereichsweise die Leiterplatte 10 durchsetzt. Auf einem Substratmaterial der Leiterplatte 10 oder in die Leiterplatte 10 eingebracht ist zumindest eine, vorzugsweise jedoch mehrere, Leiterbahnen 9 aus einem elektrisch leitfähigen Material, z.B. aus einem Metall wie Kupfer oder Platin, wobei die Leiterbahn als Bestandteil der Leiterplatte verstanden werden kann. Das Substratmaterial wird insbesondere aus einem elektrischen Isolator, so z.B. aus Keramik, gebildet. Für Hochtemperaturanwendungen sind Niedertemperatur-Einbrand-Keramiken (engl. Low Temperature Cofired Ceramics, LTTC) besonders bevorzugt.

Das Magnetfeld der Magnetvorrichtung 6 kann bevorzugt derart ausgerichtet sein, dass die Feldlinien des Magnetfeldes zumindest in einem Bereich des Magnetfeldes senkrecht zur Plattenebene der Leiterplatte 10 verlaufen.

Die Leiterbahn 9 ist zumindest bereichsweise spiralförmig auf oder in die Leiterplatte 10 auf und/oder eingebracht. Die Leiterbahn weist zudem zwei Kontaktierungselement 8 zum Abgriff eines Messsignals mittels eines hier nicht-dargestellten Anschlusselementes auf. Eine entsprechende Anordnung einer Leiterplatte 10 mit einer Leiterbahn 9 wird üblicherweise als Leiterplattenspule 7 oder pcb-Spule (printed circuit board) bezeichnet. Die Leiterplatte 7 und die Magnetvorrichtung 6 sind im Rahmen der vorliegenden Erfindung als Anordnung 3 zur Erzeugung von Rohrschwingungen und/oder zum Abgriff eines rohrschwingungsbedingten Messsignals definiert.

Sofern ein rohrschwingungsbedingtes Messsignal abgegriffen werden soll, so kann ein solches Messsignal durch Relativbewegung der Leiterplatte 10 zum Magnetfeld der Magnetvorrichtung 6, insbesondere eine Spannung, induziert werden. Sofern die Anordnung 3 zur Anregung einer Rohrschwingung genutzt werden soll, so wird durch Einspeisen eines Wechselstromsignals, beispielsweise bei einer Resonanzfrequenz der gegeneinander schwingenden Messrohre 2, durch die Leiterbahn 9 in Kombination mit dem Magnetfeld der Magnetvorrichtung 6 eine Kraft, insbesondere eine Lorenzkraft, erzeugt.

In Fig. 1 ist nur eine Leiterbahn 9 sichtbar, allerdings können auch mehrere Leiterbahnen 9 übereinander gestapelt werden und mit jeweils einer Lage aus dem Substratmaterial beabstandet werden. In einer bevorzugten Ausführungsvariante ist die oberste - also eigentlich freiliegende - Leiterbahn 9 und/oder die gesamte Leiterplatte 10 mit einer Schutzschicht, z.B. einer Glasschicht, versehen, welche als Schutz vor mechanischer Zerstörung der obersten Leiterbahn 9 dient. Die Leiterplatte 7 oder Die Magnetvorrichtung 6 ist auf einem ersten der beiden Messrohre 2 angeordnet. Das komplementäre Bauteil der Anordnung 3, also die jeweils der Leiterplatte 7 zugeordnete Magnetvorrichtung 6 oder die der Magnetvorrichtung 6 zugeordnete Leiterplatte 7 kann am zweiten der beiden Messrohre 2 oder an einem weiteren Element im oder am Messaufnehmergehäuse 5 angeordnet sein.

Falls die Spulenvorrichtungen an einem Trägerkörper befestigt sind, können die elektrischen Verbindungen entlang des Trägerkörpers geführt werden. In diesem Fall ermöglicht die erfindungsgemäße Anordnung von Kontaktierungselementen gleichlange elektrische Verbindungen und eine gleiche Führung der elektrischen Verbindungen.

Alternativ kann der Messaufnehmer beispielsweise nur ein Messrohr aufweisen, wobei eine Magnetvorrichtung eines jeweiligen Schwingungssensors beispielsweise am Messrohr befestigt ist, und die zugehörige Spulenvorrichtung am Trägerkörper oder umgekehrt, oder auch mehr als zwei Messrohre aufweisen. Der Fachmann wird die Spulenvorrichtungen entsprechend seiner Bedürfnisse einrichten. Das mindestens eine Messrohr 2 kann wie hier dargestellt zumindest einen Bogen aufweisen oder auch geradlinig verlaufen. Die Anwendbarkeit der Spulenvorrichtung ist unabhängig von einer Messrohrgeometrie.

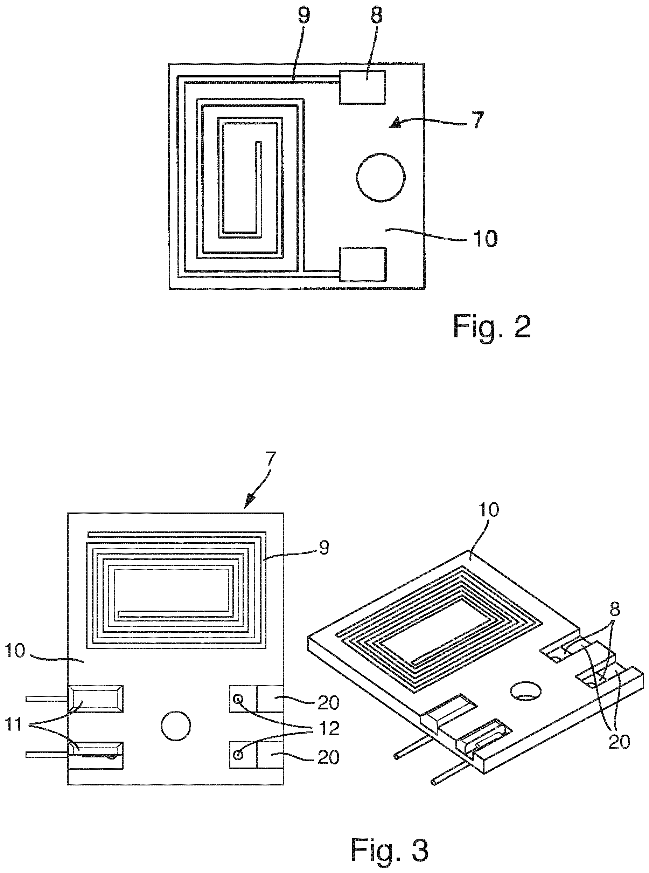

In Fig. 2 ist die Anordnung der Leiterbahn 9 auf der Leiterplatte 7 nochmals im Detail durch eine Draufsicht dargestellt. Diese Form der Leiterplatte 7 und Kontaktierungselemente 8 ist Stand der Technik und weist den Nachteile auf, dass sich Anschlusselemente 22, die an die Kontaktierungselemente 8 angeschweißt werden, bereits durch Wirken geringster Drehkräfte auf das Anschlusselement vom Kontaktierungselement 8 ablösen.

Fig. 3 zeigt eine Draufsicht auf eine erfindungsgemäßen Ausgestaltung einer Leiterplattenspule 7 mit einer Leiterplatte 10, welche mehrere Leiterplattenschichten mit jeweils einer ersten Seitenfläche und einer zweiten Seitenfläche aufweist. Eine Spule 9 mit einem ersten Spulenende und einem zweiten Spulenende (nicht sichtbar) ist in Form einer elektrisch leitfähigen Leiterbahn 9 wie hier dargestellt auf eine erste Seitenfläche aufgebracht. Die Leiterplattenspule 7 weist vier Kontaktierungselemente 8 auf, wobei zwei auf einer Seite befindlichen Kontaktierungselemente 8 ein Paar bilden. Das erste Paar Kontaktierungselemente ist dabei mittels eines ersten Anschlusses mit dem ersten Spulenende verbunden, und das zweite Paar Kontaktierungselemente ist dabei mittels eines zweiten Anschlusses mit dem zweiten Spulenende verbunden. Die Kontaktierungselemente 8 eines Paares sind dabei jeweils auf verschiedenen Seiten einer Schnittebene, einer ersten Seite und einer zweiten Seite angeordnet, so dass elektrische Verbindungen zur elektronischen Mess- und/oder Betriebsschaltung einseitig, also entweder über die erste Seite oder über die zweite Seite an die Spulenvorrichtung 7 anschließbar sind. Auf diese Art und Weise kann eine Führung der elektrischen Verbindungen sicher eingerichtet werden, so dass Leitungsbrüche und unterschiedliche Kabellängen vermieden werden können.

Des Weiteren zeigt Fig. 3 eine Schrägansicht einer erfindungsgemäßen Ausgestaltung einer Leiterplattenspule 7 mit Einbuchtungen 20 in der Leiterplatte 10, in die Kontaktierungselemente 8 angeordnet sind. Zwei Einbuchtungen 20 weisen keine Sinterkontakte 11 auf. Es ist außerdem sichtbar, dass die Kontaktierungselemente 8 dieser beiden Einbuchtungen 20 jeweils ein Loch 12, insbesondere ein Durchgangsloch aufweisen.

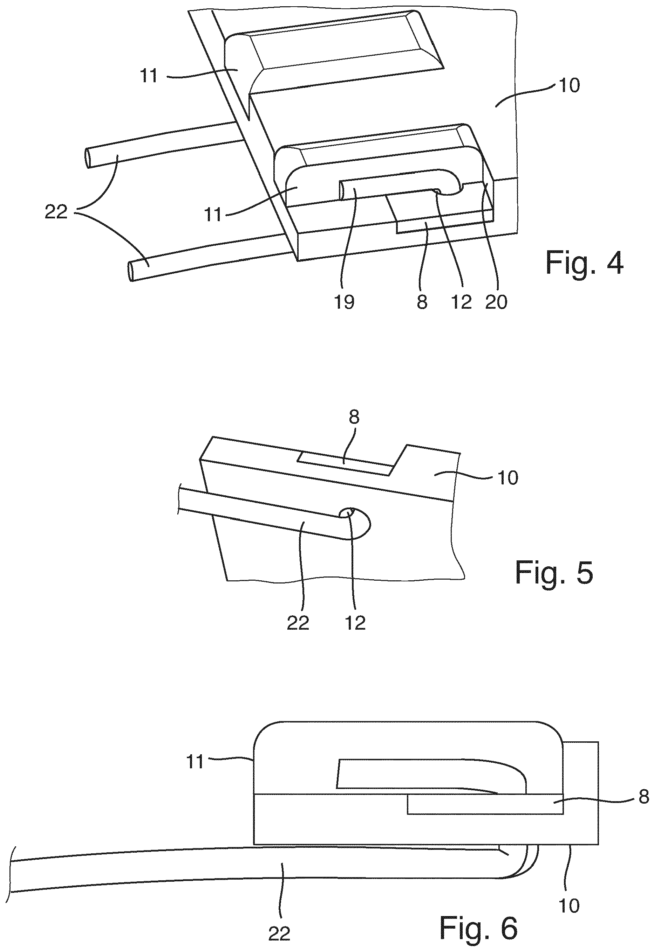

Die Fig. 4 zeigt eine Vergrößerungsansicht der Kontaktierungselemente 8, der Einbuchtung 20, der Sinterkontakte 11 und der Anschlusselemente 22. Dabei ist eine Anschlusselement 22 hakenförmig ausgebildet und durch das Loch 12 in dem Kontaktierungselement 8 geführt. Das Loch 12 ist dabei als Durchgangsloch ausgebildet und verläuft durch die Leiterplatte 10 und das Konaktierungselement 8. Die elektrische Kontaktierung erfolgt über den Sinterkontakt 11. Ein Sinterkontakt ist nur zur Hälft abgebildet, so dass ein Teil des Endes des Anschlusselementes sichtbar ist. Beim Sintern wird eine Metallmikropartikelmasse in die Einbuchtung 20 gefüllt, so dass das Ende 19 oder ein Teil des Endes 19 des Anschlusselementes 22 umschlossen und die Oberfläche des Kontaktierungselementes 8 bedeckt ist. Durch Sintern bildet sich der Sinterkontakt 11 und somit auch eine stoffschlüssige Verbindung. Durch das Umschließen des Endes 19 wird vermieden dass der elektrische Kontakt zum Kontaktierungselement 8 durch Drehkräfte verloren geht, die auf das Anschlusselement 22 wirken. Durch die Hakenform des Anschlusselementes 22 löst sich das Ende 19 bei wirkenden Zug-, Scher-, Druck-, Biege- und/oder Drehkräften nicht vom Kontaktierungselement 8 ab.

Die Fig. 5 zeigt eine Schrägansicht auf die Rückseite einer erfindungsgemäßen Ausgestaltung. In dieser Ausgestaltung ist das Anschlusselement 22 von der Rückseite der Leiterplatte 10 aus durch das Loch 12 geführt. Dies ist besonders vorteilhaft, da Kräfte, die bei Montageprozessen auftreten, nicht oder nur vermindert auf den Sinterkontakt wirken und somit ein Ablösen der Metallmikropartikelmasse verhindert.

Fig. 6 zeigt eine Vergrößerungsansicht eines Querschnittes einer erfindungsgemäßen Ausgestaltung. Das Anbindungselement 22 ist hakenförmig ausgebildet und lässt sich in drei Teile einteilen. Zum Einen das erste Teil, das Ende 19, dass von der Metallmikropartikelmasse umschlossen ist und im elektrischen Kontakt zum Kontaktierungselement 8 steht. Ein zweiter Teil, der länger als der erste Teil ist, führt zur Mess- und/oder Betriebsschaltung und bildet somit einen elektrische Verbindung. Der dritte Teil liegt zwischen dem ersten und zweiten Teil und befindet sich in dem Loch der Leiterplatte. Die jeweiligen Teile bilden sich durch Biegen des Anschlusselementes 22 an unterschiedlichen Positionen.

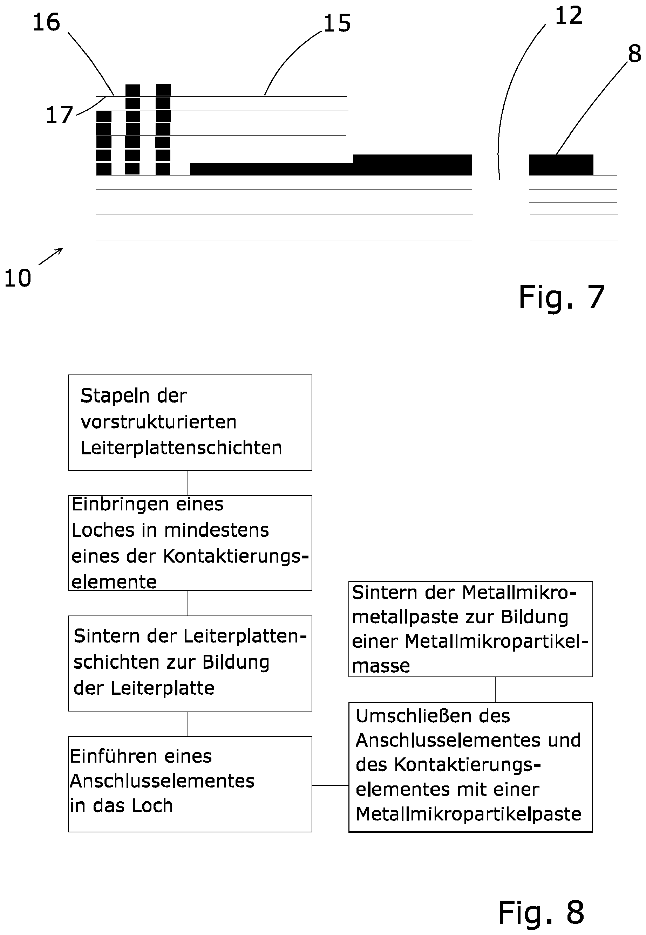

Wie in Fig. 7 dargestellt, kann eine Leiterplatte 10 mehrere Leiterplattenschichten 15 aufweisen, wobei mehrere Leiterplattenschichten 15 jeweils eine Spule aufweisen. Die Spulen mehrerer Leiterplattenschichten sind dabei über Durchkontaktierungen verbunden, so dass die Spulen verschiedener Leiterplattenschichten 15 bei Anlegen einer elektrischen Spannung zwischen den Durchkontaktierungen konstruktiv interferierende Magnetfelder erzeugen. Beispielsweise kann eine erste Durchkontaktierung erste Spulenenden und eine zweite Durchkontaktierung zweite Spulendenden verschiedener Spulen miteinander verbinden. Dies entspricht einer Parallelschaltung verschiedener Spulen. Alternativ können benachbarte Spulen über benachbarte Spulenenden miteinander verbunden sein, wobei ein erstes Spulenende einer äußeren Spule mit dem ersten Anschluss verbunden ist, und wobei ein zweites Spulenende einer weiteren äußeren Spule mit dem zweiten Anschluss verbunden ist, und wobei benachbarte Spulenenden mittels einer Durchkontaktierung verbunden sind. Dies entspräche einer Serienschaltung verschiedener Spulen. Die Kontaktierungselemente 8 können in Einbuchtungen 20 angeordnet sein, welche beispielsweise wie hier in der Seitenansicht gezeigt durch Einkerbungen einer zusammenhängenden Gruppe von Leiterplatten 15 ausgebildet ist. Die eine Einbuchtung 20 bildende zusammenhängende Gruppe kann bei verschiedenen Kontaktierungselementen 8 verschieden sein. Nicht notwendigerweise alle Kontaktierungselemente 8 sind auf einer Leiterplatte 10 angeordnet. Anstatt einer Einkerbung kann eine Leiterplatte auch eine geringere Abmessung wie zumindest eine benachbarte Leiterplatte aufweisen, so dass ein Kontaktierungselement 8 nicht durch die Leiterplattenschichten 15 mit geringeren Abmessungen bedeckt wird. Die Einbuchtung 20 weist erfindungsgemäß ein Loch 12 auf, dass durch das Kontaktierungselement 8 und die darunterliegenden Leiterplattenschichten 15 verläuft. Das Loch 12 kann einzeln bei jeder Leiterplattenschicht 15, nach dem Schichten der Leiterplattenschichten 15 oder auch nach dem Sintern der Leiterplattenschichten 15 zur Bildung der Leiterplatte 10 eingearbeitet sein. Das Loch 12 kann als Sackloch oder auch als Durchgangsloch ausgebildet sein. Das Kontaktierungselement 8 ist in dieser Ausgestaltung ein auf das Spulenende und/oder auf den Spulenanfang der Leiterplattenspule aufgebrachtes Kontaktpad. Es kann aber auch nur das Spulenende und/oder den Spulenanfang der Leiterplattenspule umfassen.

Die Fig. 8 zeigt eine Verfahrenskette zur Herstellung einer erfindungsgemäßen Spulenvorrichtung. In einem ersten Verfahrensschritt werden vorstrukturierte und mit elektrisch leitfähigen Strukturen versehene Leiterplattenschichten gestapelt. Es ist besonders vorteilhaft, wenn in einem zweiten Verfahrensschritt Löcher in die vorgesehenen Positionen eingebracht werden. Dies geschieht vorteilhafterweise durch ein Stanzverfahren. Nachdem die Löcher in die jeweiligen Kontaktierungselemente eingebracht wurden, werden die Leiterplattenschichten und die darauf aufgebrachten elektrisch leitfähigen Strukturen gesintert. Dadurch werden die organischen Bestandteile ausgebrannt und die einzelnen Leiterplattenschichten verbinden sich zu einer Leiterplatte. Im dritten Schritt werden die Anschlusselemente in die jeweiligen Löcher eingeführt. Dies geschieht vorzugsweise durch das rückseitige Einführen eines Anschlussdrahtes durch das Loch der Leiterplatte und Verbiegen des Anschlussdrahtes, so dass sich eine hakenförmiges Struktur ausbildet. Im nächsten Schritt wird ein Ende des elektrischen Anschlusselementes in der Einbuchtung von der Metallmikropartikelpaste umschlossen wird. Dies kann durch Positionieren des ersten Endes in der Einbuchtung und anschließendes zumindest teilweises Füllen mit der Metallmikropartikelpaste bewerkstelligt werden, oder durch zumindest teilweises Füllen der Einbuchtung mit der Metallmikropartikelpaste und anschließendes Einführen des Endes des elektrischen Anschlusselementes durch das Loch in die Einbuchtung. In einem letzten Verfahrensschritt wird die Metallmikropartikelpaste getrocknet, wobei der Trocknungsprozess ein Aushärten der Metallmikropartikelpaste zur Folge hat, so dass eine Metallmikropartikelmasse verbleibt. Bevorzugt weisen Partikel der Metallmikropartikelpaste eine maximale Ausdehnung von kleiner als 50 Mikrometer, und insbesondere kleiner als 35 Mikrometer und bevorzugt kleiner als 25 Mikrometer auf, da somit eine Haftung der Partikel aneinander und an Unebenheiten der Umrandung für einen festen Sitz der Metallmikropartikelmasse in der Umrandung sichergestellt ist. Der Trocknungsprozess umfasst ein Erwärmen der Metallmikropartikelpaste 5 auf eine Trocknungstemperatur von mindestens 150°C, und insbesondere mindestens 180°C, und bevorzugt mindestens 210°C, um ein gutes Aushärten der Metallmikropartikelpaste zu unterstützen. Des Weiteren kann der Trocknungsprozess ein Halten der Trocknungstemperatur über mindestens 20 Minuten, und insbesondere mindestens 10 Minuten, und bevorzugt mindestens 50 Minuten umfassen, um ein gutes Aushärten der Metallmikropartikelpaste zu unterstützen. Um ein gleichmäßiges Aushärten zu unterstützen, kann eine Temperaturanpassung von Zimmertemperatur zu Trocknungstemperatur und/oder von Trocknungstemperatur zu Zimmertemperatur eine Zeitdauer von mindestens 20 Minuten, und insbesondere mindestens 35 Minuten, und bevorzugt mindestens 50 Minuten umfassen. Das Trocknen sowie die das Aushärten kann auch Sinterprozesse zwischen verschiedenen Partikeln mit einschließen.

Es kann vorteilhaft sein, das Trocken der Metallmikropartikelpaste in einer Hochdruckatmosphäre von mindestens 3 Bar, und bevorzugt mindestens 5 Bar und insbesondere mindestens 10 Bar durchzuführen, auf diese Weise lassen sich Sintervorgänge zwischen einzelnen Partikeln der Metallmikropartikelpaste unterstützen.

### Bezugszeichenliste

- **1**: Messaufnehmer
- **2**: Messrohr
- **3**: Anordnung zur Erzeugung von Rohrschwingungen und/oder zum Abgriff eines rohrschwingungsbedingten Messsignals
- **3.I**: Schwingungssensor
- **3.II**: Schwingungserreger
- **3.III**: Schwingungssensor
- **4**: Messumformer
- **5**: Messaufnehmergehäuse
- **6**: Magnetvorrichtung
- **7**: Leiterplattenspule
- **8**: Kontaktierungselement
- **9**: Leiterbahn
- **10**: Leiterplatte
- **11**: Sinterkontakt
- **12**: Loch
- **13**: Mess- und/oder Betriebsschaltung
- **14**: Spulenvorrichtung
- **15**: Leiterplattenschicht
- **16**: erste Seitenfläche
- **17**: zweite Seitenfläche
- **18**: Spule
- **19**: Ende
- **20**: Einbuchtung
- **21**: Boden
- **22**: Anschlusselement
- **23**: Metallmikropartikelpaste
- **24**: Feldgerät
- **25**: elektrische Verbindung

## Patentansprüche

1. Messaufnehmer (1) eines Messgerätes zum Erfassen eines Massedurchflusses, einer Viskosität, einer Dichte und/oder einer davon abgeleiteten Größe eines durch mindestens ein Messrohr (2) des Messaufnehmers (1) strömenden Mediums, umfassend:
- das mindestens eine Messrohr (2) mit einem Einlauf und einem Auslauf, welches dazu eingerichtet ist, das Medium zwischen Einlauf und Auslauf zu führen;
- mindestens einen Schwingungserreger (3.II), welcher dazu eingerichtet ist, das mindestens eine Messrohr (2) zu Schwingungen anzuregen; und
- mindestens zwei Schwingungssensoren (3.I, 3.III), welche dazu eingerichtet sind, die Auslenkung der Schwingungen mindestens eines Messrohrs (2) zu erfassen,
wobei mindestens ein Schwingungserreger (3.II) sowie die Schwingungssensoren (3.I, 3.III) jeweils eine Spulenvorrichtung mit jeweils mindestens einer Spule (17), sowie jeweils eine Magnetvorrichtung (6) aufweisen, wobei die Magnetvorrichtung (6) und die Spulenvorrichtung relativ zueinander bewegbar sind,
wobei die Magnetvorrichtung (6) und die Spulenvorrichtung eines Schwingungserregers (3.I) bzw. Schwingungssensors (3.I, 3.III) dazu eingerichtet sind, mittels magnetischer Felder miteinander zu wechselwirken,
wobei die Spulenvorrichtung eine Leiterplatte (10) mit mindestens einer Leiterplattenschicht (15) umfasst,
wobei jede Leiterplattenschicht (15) eine erste Seitenfläche (16) und zur ersten Seitenfläche (16) planparallele zweite Seitenfläche (17) aufweist;
wobei die Spule (15) dazu eingerichtet ist ein zeitlich varrierendes Magnetfeld zu erfassen oder zu erzeugen,
wobei die Spule (15) zumindest abschnittsweise mittels einer elektrisch leitfähigen Leiterbahn (9) ausgebildet ist,
wobei die Spule (15) auf der ersten Seitenfläche (16) und/oder zweiten Seitenfläche (17) einer Leiterplattenschicht angeordnet ist,
wobei die Leiterplatte (10) mindestens zwei Kontaktierungselemente (8) umfasst, zum Anschließen der Spule (17) an eine elektronische Mess- und/oder Betriebsschaltung (13) des Messgerätes mittels Anschlusselementen (22); **dadurch gekennzeichnet,**
**dass** mindestens ein Kontaktierungselement (8) ein Loch (12) aufweist,
wobei die Leiterplatte (10) mindestens eine Einbuchtung (20) mit einem Boden (21) aufweist,
wobei jeweils ein Kontaktierungselement (8) auf dem Boden (21) jeweils einer Einbuchtung (20) angeordnet ist,
wobei das Anschlusselement (22) in der Einbuchtung (20) angeordnet ist,
wobei die Einbuchtung (20) zumindest teilweise mit einer festen Metallmikropartikelmasse (23) gefüllt ist, welche das Anschlusselement (22) stoffschlüssig mit der Leiterplatte (9) und dem Kontaktierungselement (8) verbindet und einen elektrischen Kontakt zwischen dem Anschlusselement (22) und dem Kontaktierungselement (8) vermittelt.

2. Messaufnehmer (1) nach Anspruch 1,
wobei ein Anschlusselement (22) durch das Loch (12) geführt ist, so dass das Anschlusselement (22) zumindest einseitig, formschlüssig mit der Leiterplatte (10) verbunden ist.

3. Messaufnehmer (1) nach einem der vorherigen Ansprüche,
wobei ein Ende (19) des ersten Anschlusselementes (22) zumindest abschnittsweise gebogen, geknickt oder hakenförmig ausgebildet ist,
wobei das Ende (19) in das Loch (12) durchgeführt oder zumindest eingeführt ist.

4. Messaufnehmer (1) nach einem der vorherigen Ansprüche,
wobei das Anschlusselement (22) einen Anschlussdraht umfasst, der zumindest ein Metall aus folgender Liste aufweist: Silber, Gold, Kupfer, Platin, Tantal, Paladium.

5. Messaufnehmer (1) nach mindestens einem der vorherigen Ansprüche,
wobei die Metallmikropartikelmasse (23) Mikropartikel zumindest eines Metalls aus folgender Liste aufweist: Silber, Gold, Kupfer, Platin, Tantal, Paladium.

6. Messaufnehmer (1) nach einem der Ansprüche 1 bis 5,
wobei das Loch (12) als Durchgangsloch ausgebildet ist und durch das Kontaktierungselement (8) und die Leiterplatte (10) verläuft.

7. Verfahren zur Herstellung einer Spulenvorrichtung eines Messaufnehmers (1) nach einem der vorherigen Ansprüchen, umfassend die folgenden Verfahrensschritte:
- Einbringen eines Loches (12) in eines der Kontaktierungselemente (8), insbesondere eines Durchgangsloches in eines der Kontaktierungselemente (8) und die Leiterplatte (9);
- Einführen des Anschlusselementes (22) in das Loch (12);
- teilweises Umschließen des Anschlusselementes (22) und des Kontaktierungselementes (8) mit einer Metallmikropartikelpaste (23); und
- Trocknen, Aushärten und/oder Sintern der Metallmikropartikelpaste zur Bildung einer Metallmikropartikelmasse (23).

8. Verfahren nach Anspruch 7,
wobei die Leiterplatte (10) eine Einbuchtung (20) aufweist in der das Kontaktierungselement (8) angeordnet ist,
wobei das Umschließen des Anschlusselementes (22) und der Kontaktierungselemente (8) durch Füllen der Einbuchtung (20) mit der Metallmikropartikelpaste erfolgt.

9. Verfahren nach Anspruch 7,
wobei das Trocknen ein Erwärmen der Metallmikropartikelpaste auf eine Trocknungstemperatur von mindestens 150°C, und insbesondere mindestens 180°C, und bevorzugt mindestens 210° C umfasst.

10. Verfahren nach Anspruch 7,
wobei das Trocknen ein Halten der Trocknungstemperatur über mindestens 20 Minuten, und insbesondere mindestens 35 Minuten, und bevorzugt mindestens 50 Minuten umfasst.

11. Verfahren nach einem der Ansprüche 7 bis 10,
wobei eine Temperaturanpassung von Zimmertemperatur zu Trocknungstemperatur und/oder von Trocknungstemperatur zu Zimmertemperatur eine Zeitdauer von mindestens 20 Minuten, und insbesondere mindestens 35 Minuten, und bevorzugt mindestens 50 Minuten umfasst.

12. Verfahren nach einem der Ansprüche 7 bis 11,
wobei Partikel der Metallmikropartikelpaste eine maximale Ausdehnung von kleiner als 50 Mikrometer, und insbesondere kleiner als 35 Mikrometer und bevorzugt kleiner als 20 Mikrometer aufweisen.

13. Verfahren nach einem der Ansprüche 7 bis 12,
wobei das Loch (12) mittels eines Stanzverfahrens oder eines Laserverfahrens ausgebildet ist.

14. Verfahren nach einem der Ansprüche 7 bis 13,
wobei zur Bildung der Leiterplatte (10), vorstrukturierte Leiterplattenschichten (15), insbesondere Keramikfolien gestapelt und gesintert werden,
wobei das Einbringen des Loches (12) in das Kontaktierungselement (8) vor oder nach dem Sintern erfolgt.

15. Feldgerät der Prozessmesstechnik (24), umfassend:
- einen Messaufnehmer (1) nach einem der Ansprüche 1 bis 6; und
- eine elektronische Mess- und/oder Betriebsschaltung (13),
wobei die elektronische Mess- und/oder Betriebsschaltung (13) dazu eingerichtet ist, die Schwingungssensoren (3.I, 3.III) und den Schwingungserreger (3.II) zu betreiben, und mittels elektrischer Verbindungen (25) mit diesen verbunden ist,
wobei die elektronische Mess- und/oder Betriebsschaltung (13) weiter dazu eingerichtet ist, Durchflussmesswerte und/oder Dichtemesswerte zu ermitteln und bereitzustellen.

## Claims

1. A sensor (1) of a measuring device for detecting a mass flow, a viscosity, a density, and/or a variable derived therefrom of a medium flowing through at least one measuring tube (2) of the sensor (1), comprising:
- the at least one measuring tube (2) with an inlet and an outlet, said tube being configured to conduct the medium between the inlet and outlet;
- at least one vibration generator (3.11) which is configured to cause the at least one measuring tube (2) to vibrate; and
- at least two vibration sensors (3.1, 3.111) which are configured to detect the deflection of the vibrations of the at least one measuring tube (2),
wherein at least one vibration generator (3.11) and the vibration sensors (3.1, 3.111) each have a coil device with at least one coil (17) in each case, and at least one magnetic device (6) in each case, wherein the magnetic device (6) and the coil device can be moved relative to each other,
wherein the magnetic device (6) and the coil device of a vibration generator (3.1) or vibration sensor (3.1, 3.111) are configured to interact with each other through magnetic fields,
wherein the coil device comprises a PCB (10) with at least one PCB layer (15),
wherein each PCB layer (15) has a first lateral surface (16) and a second lateral surface (17) which is plane-parallel to the first lateral surface (16);
wherein the coil (15) is configured to detect or generate a time-varying magnetic field,
wherein the coil (15) is formed by an electrically conductive trace (9) in at least sections,
wherein the coil (15) is arranged on the first lateral surface (16) and/or second lateral surface (17) of a PCB layer,
wherein the PCB (10) comprises at least two contacting elements (8) for connecting the coil (17) to an electronic measuring and/or operating circuit (13) of the measuring device using connecting elements (22); **characterized in that** at least one contacting element (8) has a hole (12), wherein the PCB (10) has at least one indentation (20) with a base (21),
wherein each contacting element (8) on the base (21) is assigned to an indentation (20),
wherein the connecting element (22) is arranged in the indentation (20),
wherein the indentation (20) is at least partly filled with a solid metallic microparticle mass (23) which creates a material bond between the connecting element (22) and the PCB (9) and the contacting element (8) and transfers electrical contact between the connecting element (22) and the contacting element (8).

2. The sensor (1) as claimed in claim 1,
wherein a connecting element (22) is guided through the hole (12) so that the connecting element (22) has a positive-locking connection with the PCB (10) on at least one side.

3. The sensor (1) as claimed in one of the preceding claims,
wherein an end (19) of the first connecting element (22) is bent, kinked or hooked at least in sections,
wherein the end (19) is guided through the hole (12) or at least inserted into it.

4. The sensor (1) as claimed in one of the preceding claims,
wherein the connecting element (22) comprises a connecting wire which has at least one metal from the following list: Silver, gold, copper, platinum, tantalum, palladium.

5. The sensor (1) as claimed in at least one of the preceding claims,
wherein the metallic microparticle mass (23) has microparticles of at least one metal from the following list: Silver, gold, copper, platinum, tantalum, palladium.

6. The sensor (1) as claimed in one of claims 1 to 5,
wherein the hole (12) is formed as a through-hole and extends through the contacting element (8) and the PCB (10).

7. A method for producing a coil device of a sensor (1) as claimed in one of the preceding claims, comprising the following process steps:
- Making a hole (12) in one of the contacting elements (8), in particular a through-hole in one of the contacting elements (8) and the PCB (9);
- Inserting the connecting element (22) into the hole (12);
- Partly surrounding the connecting element (22) and the contacting element (8) with a metallic microparticle paste (23); and
- Drying, curing and/or sintering of the metallic microparticle paste to form a metallic microparticle mass (23).

8. The method as claimed in claim 7,
wherein the PCB (10) has an indentation (20) in which the contacting element (8) is arranged,
wherein the connecting element (22) and the contacting elements (8) are surrounded by filling the indentation (20) with the metallic microparticle paste.

9. The method as claimed in claim 7,
wherein the drying step comprises heating the metallic microparticle paste to a drying temperature of at least 150 °C, and in particular at least 180 °C, and preferably at least 210 °C.

10. The method as claimed in claim 7,
wherein the drying step comprises keeping the metallic microparticle paste at the drying temperature for at least 20 minutes, and in particular at least 35 minutes, and preferably at least 50 minutes.

11. The method as claimed in one of claims 7 to 10,
wherein a temperature adjustment from room temperature to the drying temperature and/or from the drying temperature to room temperature covers a duration of at least 20 minutes, and in particular at least 35 minutes, and preferably at least 50 minutes.

12. The method as claimed in one of claims 7 to 11,
wherein particles of the metallic microparticle paste have a maximum elongation of less than 50 micrometers, and in particular less than 35 micrometers, and preferably less than 20 micrometers.

13. The method as claimed in one of claims 7 to 12,
wherein the hole (12) is formed by means of a punching process or a lasering process.

14. The method as claimed in one of claims 7 to 13,
wherein prestructured PCB layers (15), in particular ceramic sheets, are stacked and sintered to form the PCB (10),
wherein the hole (12) is made in the contacting element (8) before or after sintering.

15. A process measuring technology field device (24), comprising:
- a sensor (1) as claimed in one of claims 1 to 6; and
- a electronic measuring and/or operating circuit (13),
wherein the electronic measuring and/or operating circuit (13) is configured to operate the vibration sensors (3.1, 3.111) and the vibration generator (3.11), and is connected thereto by means of electrical connections (25),
wherein the electronic measuring and/or operating circuit (13) is furthermore configured to determine and provide measured flow values and/or measured density values.

## Revendications

1. Capteur (1) d'un appareil destiné à la mesure d'un débit massique, d'une viscosité, d'une densité et/ou d'une grandeur qui en est dérivée, d'un produit s'écoulant à travers au moins un tube de mesure (2) du capteur (1), lequel capteur comprend :
- l'au moins un tube de mesure (2) avec une entrée et une sortie, lequel tube est conçu pour guider le produit entre l'entrée et la sortie ;
- au moins un excitateur de vibrations (3.II), lequel est conçu pour faire vibrer l'au moins un tube de mesure (2) ; et
- au moins deux capteurs de vibrations (3.I, 3.III), lesquels sont conçus pour mesurer la déviation des vibrations d'au moins un tube de mesure (2),
au moins un excitateur de vibrations (3.11) ainsi que les capteurs de vibrations (3.I, 3.III) présentant chacun un dispositif de bobine avec chacun au moins une bobine (17), ainsi que chacun un dispositif magnétique (6), le dispositif magnétique (6) et le dispositif de bobine étant mobiles l'un par rapport à l'autre, le dispositif magnétique (6) et le dispositif de bobine d'un excitateur de vibrations (3.I) ou d'un capteur de vibrations (3.I, 3.III) étant adaptés pour interagir l'un avec l'autre au moyen de champs magnétiques,
le dispositif de bobine comprenant une carte de circuit imprimé (10) avec au moins une couche de carte de circuit imprimé (15),
chaque couche de carte de circuit imprimé (15) présentant une première surface latérale (16) et une deuxième surface latérale (17) parallèle à la première surface latérale (16) ;
la bobine (15) étant conçue pour détecter ou générer un champ magnétique variant dans le temps,
la bobine (15) étant réalisée au moins par sections au moyen d'une piste (9) électriquement conductrice,
la bobine (15) étant disposée sur la première surface latérale (16) et/ou la deuxième surface latérale (17) d'une couche de carte de circuit imprimé,
la carte de circuit imprimé (10) comprenant au moins deux éléments de contact (8) destinés au raccordement de la bobine (17) à un circuit électronique de mesure et/ou de fonctionnement (13) de l'appareil de mesure au moyen d'éléments de raccordement (22) ; **caractérisé en ce**
**qu'**au moins un élément de contact (8) présente un trou (12),
la carte de circuit imprimé (10) présentant au moins un renfoncement (20) avec un fond (21),
un élément de contact (8) étant respectivement disposé sur le fond (21) d'un renfoncement (20) respectif,
l'élément de raccordement (22) étant disposé dans le renfoncement (20),
le renfoncement (20) étant au moins partiellement rempli d'une masse solide de microparticules métalliques (23) qui relie l'élément de raccordement (22) par liaison de matière à la carte de circuit imprimé (9) et à l'élément de contact (8) et qui transmet un contact électrique entre l'élément de raccordement (22) et l'élément de contact (8).

2. Capteur (1) selon la revendication 1,
pour lequel un élément de raccordement (22) est guidé à travers le trou (12), de sorte que l'élément de raccordement (22) est relié au moins d'un côté, par complémentarité de forme, à la carte de circuit imprimé (10).

3. Capteur (1) selon l'une des revendications précédentes,
pour lequel une extrémité (19) du premier élément de raccordement (22) est réalisée au moins par sections de manière courbée, pliée ou en forme de crochet, l'extrémité (19) étant passée ou au moins introduite dans le trou (12).

4. Capteur (1) selon l'une des revendications précédentes,
pour lequel l'élément de raccordement (22) comprend un fil de raccordement comprenant au moins un métal de la liste suivante : argent, or, cuivre, platine, tantale, paladium.

5. Capteur (1) selon au moins l'une des revendications précédentes,
pour lequel la masse de microparticules métalliques (23) comprend des microparticules d'au moins un métal de la liste suivante : argent, or, cuivre, platine, tantale, paladium.

6. Capteur (1) selon l'une des revendications 1 à 5,
pour lequel le trou (12) est un trou traversant et traverse l'élément de contact (8) et la carte de circuit imprimé (10).

7. Procédé destiné à la fabrication d'un dispositif de bobine d'un capteur (1) selon l'une des revendications précédentes, lequel procédé comprend les étapes suivantes :
- Réalisation d'un trou (12) dans l'un des éléments de contact (8), notamment d'un trou traversant dans l'un des éléments de contact (8) et la carte de circuit imprimé (9) ;
- Introduction de l'élément de raccordement (22) dans le trou (12) ;
- Enrobage partiel de l'élément de raccordement (22) et l'élément de contact (8) avec une pâte de microparticules métalliques (23) ; et
- Séchage, durcissement et/ou le frittage de la pâte de microparticules métalliques pour former une masse de microparticules métalliques (23).

8. Procédé selon la revendication 7,
pour lequel la carte de circuit imprimé (10) présente un renfoncement (20) dans lequel est disposé l'élément de contact (8),
l'enrobage de l'élément de raccordement (22) et des éléments de contact (8) étant réalisé par remplissage du renfoncement (20) avec la pâte de microparticules métalliques.

9. Procédé selon la revendication 7,
pour lequel le séchage comprend un échauffement de la pâte de microparticules métalliques à une température de séchage d'au moins 150 °C, et notamment d'au moins 180 °C, et de préférence d'au moins 210 °C.

10. Procédé selon la revendication 7,
pour lequel le séchage comprend un maintien de la température de séchage pendant au moins 20 minutes, et notamment au moins 35 minutes, et de préférence au moins 50 minutes.

11. Procédé selon l'une des revendications 7 à 10,
pour lequel une adaptation de température de la température ambiante à la température de séchage et/ou de la température de séchage à la température ambiante comprend une durée d'au moins 20 minutes, et notamment d'au moins 35 minutes, et de préférence d'au moins 50 minutes.

12. Procédé selon l'une des revendications 7 à 11,
pour lequel des particules de la pâte de microparticules métalliques présentent une extension maximale inférieure à 50 micromètres, et notamment inférieure à 35 micromètres et de préférence inférieure à 20 micromètres.

13. Procédé selon l'une des revendications 7 à 12,
pour lequel le trou (12) est formé au moyen d'un procédé de poinçonnage ou d'un procédé laser.

14. Procédé selon l'une des revendications 7 à 13,
pour lequel, pour former la carte de circuit imprimé (10), des couches de carte de circuit imprimé (15) préstructurées, notamment des feuilles de céramique, sont empilées et frittées,
la réalisation du trou (12) dans l'élément de contact (8) étant effectuée avant ou après le frittage.

15. Appareil de terrain de la technique de mesure de process (24), lequel appareil comprend :
- un capteur (1) selon l'une des revendications 1 à 6 ; et
- un circuit électronique de mesure et/ou de fonctionnement (13),
le circuit électronique de mesure et/ou de fonctionnement (13) étant conçu pour faire fonctionner les capteurs de vibrations (3.I, 3.III) et l'excitateur de vibrations (3.II), et lequel circuit est relié à ceux-ci au moyen de liaisons électriques (25),
le circuit électronique de mesure et/ou de fonctionnement (13) étant en outre conçu pour déterminer et mettre à disposition des valeurs mesurées de débit et/ou des valeurs mesurées de densité.
